# EUROPEAN PATENT APPLICATION

(11) **EP 1 207 733 A1**
(43) Date of publication of application: **22.05.2002**
(21) Application number: 00610116.6
(22) Date of filing: 20.11.2000
(51) Int. Cl.: H05K 9/00

(54) **Method of manufacturing items with bend projections**

(71) Applicant: LK Engineering A/S, 2100 Copenhagen (DK)
(72) Inventor: Traberg, Lars, 2100 Copenhagen Ö (DK)
(74) Representative: Kristoffersen, Bo

(57) **Abstract**

The present invention relates to a method of permanently bending a member projecting from a body, especially a finger-like spring member of an EMC gasket. According to the invention a method is provided in which at least one projecting element on a base member is bend without the use of initial clamping means, and where the at least one projecting element has a reduced thickness relative to the portion of the base member to which it is attached.

## Description

### FIELD OF THE INVENTION

The present invention relates in its broadest concept to a method of permanently bending a member projecting from a body. More specifically the present invention relates to bending a finger-like member projecting from a relatively thin sheet-member, and most specifically the present invention relates to a method of forming a spring member for a conductive EMC gasket.

### BACKGROUND OF THE INVENTION

Electromagnetic interference is a common and well-known problem associated with electronic equipment. Normal circuit operation creates electromagnetic waves which induce undesirable signals and interfere with the normal operation of other electrical components. These undesirable signals, termed electromagnetic or RF (radio frequency) interference, can be minimized by shielding portions of the circuit within a conductive shield at a low or ground potential. This grounded electromagnetic shield dissipates electrostatic build-up and absorbs the electromagnetic field thereby shielding the circuit from electromagnetic interference.

A typical field in which electromagnetic interference concerns are present is in the design of mobile phones. Depending on the actual design, it may be necessary to either shield specific components inside the apparatus itself against electromagnetic interference, in- or outgoing, or to shield the apparatus as such with a housing functioning as an overall shield.

In the past, it has been common practice to solder an electromagnetic shield to a ground trace formed on a printed circuit board of a radiotelephone. This approach obviously yields excellent conductive contact between the shield and the ground trace of the printed circuit board. However, soldering the electromagnetic shield to the printed circuit board makes inspection and repair of the printed circuit board practically impossible. It is highly desirable for the shield and printed circuit board to be of a design that readily accommodates inspection and repair.

Conductive gaskets can also be used as a conductive interface between an electromagnetic shield, either between a housing and the printed circuit or between two housing components, e.g. an upper and a lower housing for a mobile telephone.

Spring clips and fingers have been utilized in mobile phones for the purpose of maintaining conductive contact between an electromagnetic shield and a ground trace formed on a printed circuit board. See, for example, the disclosure of U.S. Pat. No. 5,053,924 in which contact-providing elastic clip members are mounted on a housing. Indeed, the mounted clip members add to the complexity, size and costs for the overall shielding device.

A more recent approach is disclosed in U.S. Pat. No. 5,748,455 which discloses an electromagnetic shield including a face and a sidewall extending around the face, and with a series of spaced apart, integrally formed spring contacts extending from the sidewall of the shield and making electrical contact with the ground trace of the printed circuit board.

As mentioned above, the electronics of, for example, a mobile phone can also be shielded by one or more conductive gaskets. For example when two or more housing parts are used to enclose the circuitry, a gasket is placed between the conductive housing parts in order to establish electrical contact between the parts which can be manufactured from either metal or metalized plastics. Such a gasket can also be used between an internal shield and a circuit board. In order to maintain conductive contact between the housing parts, the principle of spring contacts has also been utilized for the gaskets. For example, U.S. Pat. No. 5,039,825 discloses an arrangement in which a corrugated strip serves as a gasket, and where the force exerted by the corrugated strip provides electrical continuity between the conductive surfaces to be connected by the gasket.

A more recent gasket is disclosed in the brochure "EMC metal gaskets" published by LK Engineering as, DK-2100 Copenhagen, Denmark. The disclosed metal gasket consists of a frame adapted to follow the contour to be shielded, i.e. the contacting area between two components. To ensure contact the frame comprises a number of small contact springs, typically 1-1.5 mm in length integrated into the frame and bend out of the general plane of the gasket. As above, screening takes place by the springs creating electrical contact between, for example, the shield and the circuit board. To ensure low force of compression, the thickness of the springs is reduced in comparison to the frame portion of the gasket.

In general, the above-described types of gaskets may be very thin, typically 0.15 mm and comprising a large number of very small springs. Further, the gasket portions carrying the springs may have dimensions (for example the width) which is in the same range as the springs, correspondingly, creating the small contact springs in an automated process by permanently deforming (bending) portions of the gasket (or housing) has been both time-consuming and costly, the latter due to the high costs of the tools necessary, as it has been necessary to clamp the portion of the gasket next to the portion (e.g. finger-like projection) to be bend, this in order to control the bending process. If the "spring-carrying" gasket portion was not clamped it would just flex elastically together with the projection resulting in either no permanent deformation or an irregular and uncontrolled bending. Adding further to the complexity is the desire, for example for gaskets of the rim-type, to have the spring contacts bend in alternating directions.

It is therefore an object of the present invention to provide a method in which projections on a sheet-like member can be bend cost-effectively; specifically, it is an object to provide an efficient method in which finger-like projections on a metal gasket can be bend in order to provide contact springs protruding from the general plane of the gasket. It is also an object of the present invention to provide a tool as well as a method for the manufacturing of such a tool to be used with the method of the present invention.

Other objects and advantages of the present invention will become apparent and obvious from a study of the following description and the accompanying drawings, which are merely illustrative of such invention.

### SUMMARY OF THE INVENTION

The present invention is based on the realization that reducing the relative thickness of the projections to be bend as compared with the main element makes it possible to bend the projections without the need for clamping the main element.

According to the invention a method is provided in which at least one projecting element on a member (also called a base) is bend without the use of initial clamping means, and where the at least one projecting element has a reduced thickness relative to the member. Preferably the member has a sheet-like configuration with finger-like projections, and more preferably the sheet-like member comprises a plurality of extensions which are bend in opposite directions, i.e. at least on projection being bend in a first direction and at least one projection being bend in the opposite direction. The definition "without the use of clamping means" defines that the projecting element is bend between cooperating tool portions, the portion of the (sheet-like) member carrying the projecting element having at least one free surface during at least the initial bending procedure. In a preferred embodiment the sheet-like member with its projections forms an EMC metal gasket for providing effective mechanical screening against electromagnetic radiation in mobile phones, portable computers, and other forms of small and/or portable communication equipment.

According to a further aspect of the invention, a bending tool is provided, the tool having projections and recesses provided by etching technique or any other suitable technique.

Other objects and advantages of the present invention will become apparent and obvious from a study of the following description and the accompanying drawings, which are merely illustrative of such invention.

### BRIEF DESCRIPTION OF THE DRAWINGS

Figs. 1A-1I show the different stages in manufacturing a gasket blank using chemical milling, the blank being shown in sectional views;
Figs. 2A and 2B show the bending procedure according to the present invention;
Fig. 3 shows an embodiment of a tool to be used with the present invention; and
Fig. 4 shows (in partial) an actual embodiment of an EMC metal gasket which advantageously could be manufactured using the method of the present invention.

### DETAILED DESCRIPTION OF THE INVENTION

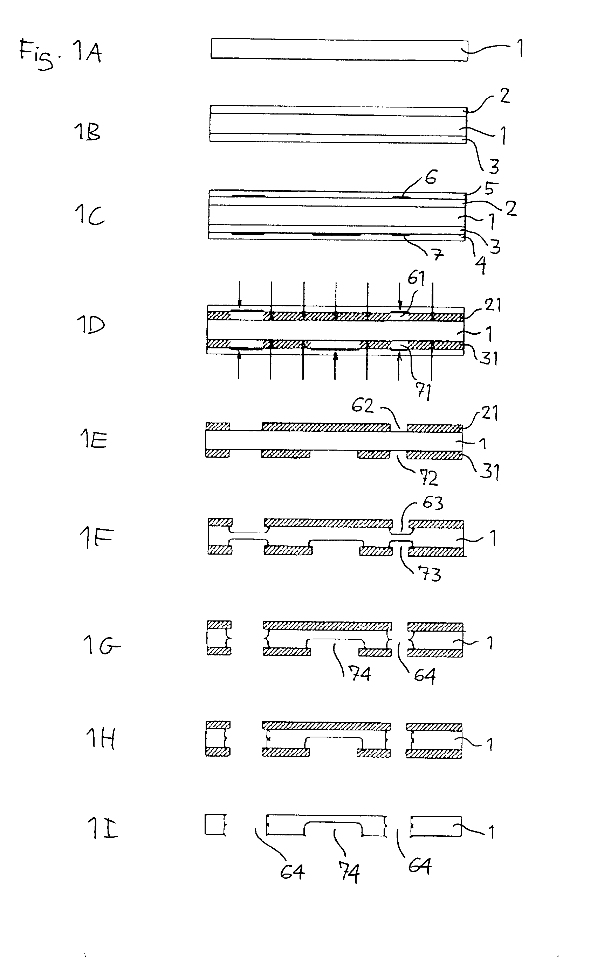

With reference to the Figs. 1A-1I a preferred method for manufacturing a gasket to be bend in accordance with the present invention will be described, i.e. a method for manufacturing a gasket comprising a number of finger-like extension having a reduced thickness, in the following called a blank. The described steps of manufacturing such a blank is not part of the present invention but is only provided for more fully understanding the present invention.

The illustrated method is normally known as chemical milling and is based on the principle that portions of a metal member, often a sheet-like member, are removed by etching from the surface of the member. Apertured masks for colour televisions are a well-known product manufactured by this technique.

In large-scale production an endless metal sheet (also called web) for a large number of items is passed through a number of stations in which the different steps are performed. Fig. 1A shows in a partial sectional view a metal web 1, which for an EMC gasket may be 0.15 mm tempered stainless steel (1800 N/mm²), and which after having been cleaned subsequently is covered with a coating 2, 3 on respective sides, see Fig. 1B. Thereafter masking foils 5, 4 with the pattern 6, 7 to be etched on the respective sides of the web are placed on top of the coating layer, see Fig. 1C. The web is then exposed to, for example, UV light (see Fig. 1D) and subsequently developed such that the exposed coating forms an etchant resist coating 21, 31 with the non-exposed areas 61, 71 of the coating being removed to leave the metal web unprotected at 62, 72 corresponding to the pattern of the mask, see Fig. 1E. It is these portions of the metal web which are to be etched during the subsequent etching procedures.

Thereafter the web is passed through one or more etching stations (not shown) wherein a plurality of upper and lower etchant spray nozzles are arranged to allow the etchant spray to be dispersed over a wide area. Fig. 1F shows that the unprotected areas 63, 73 are partly etched and Figs. 1G and 1H show that openings 64 are formed whereas the portions of the web with resist coating on only one side have given rise to areas 74 with reduced thickness. Fig. 1I shows the finished web with the resist coating removed.

The manufacturing method described with respect to Figs. 1A-1I illustrates the principle of chemical milling. However, in order to manufacture a blank to be used with the present invention, the projections to be bend will be formed as portions 74 with reduced thickness surrounded (apart from the "hinge" portion) by etched-through portions 64.

As mentioned above, a large number of items, e.g. blanks, are formed on the web, the individual blanks being connected to each other by a number of "external" bridges. If the blank is in the form of a rim-like member the "internal" portion is also connected with a number of bridges. After etching the internal web portions are removed, for example by stamping, as well as all or some of the external bridges, this resulting in either individual blanks or "biscuits" comprising a number of blanks typically arranged on a string for better handling.

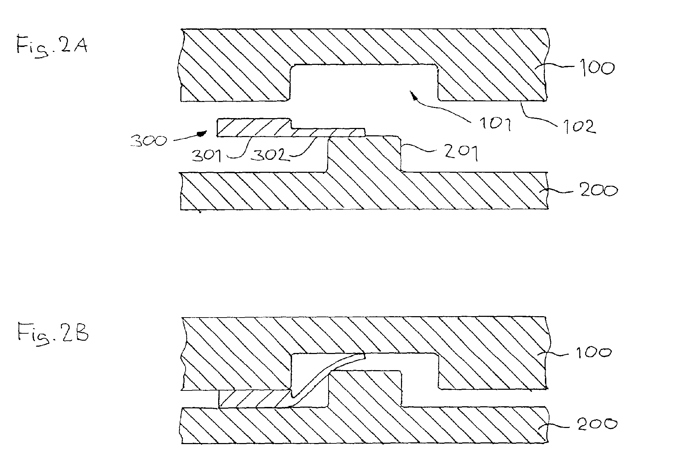

Next the bending procedures according to the present invention will be described with reference to Figs 2A and 2B. The shown bending tool comprises a first 100 and a second 200 tool portion, which in the shown embodiment represent upper and lower tool portions respectively. The two tool portions comprise corresponding bending means in the form of a recessed area 101 in the upper tool portion and a projection 201 on the lower tool portion. By the term "corresponding" is meant that the projection(s) 201 can be advanced into the recessed area(s) 101 when the two portions are properly brought into register with each other, however, apart from the recess having dimensions in the plane of the tool which are larger than the corresponding dimensions of the projection, the dimensions do not necessarily correspond to each other, e.g. the depth respectively the height can be different. Apart from the recesses and projections, the tool portions comprise a generally planar surface.

Between the two tool portions is arranged a blank 300 to be bend. The blank comprises a base portion 301 (which for an EMC gasket would be the rim-portion) from which a finger-like extension 302 projects, the extension having a reduced thickness as compared with the base portion, preferably between ½ and ¼, most preferably 1/3. For the purpose of definition, the blank has a first and a second general surface on opposite sides thereof, these surfaces also defining the corresponding surfaces on the base portion and the extension. In the shown embodiment the blank is placed on the lower tool portion with the first surface of the extension 302 arranged on the projection 201. Indeed, although only one extension is shown, the blank normally comprises several such extensions which are arranged on a corresponding number of projections on the lower tool portion. In order to correctly align the blank on the lower tool portion, corresponding guiding means should be provided, for example upstanding guide means on the lower tool portion which catch corresponding openings in the blank. In the shown embodiment the blank has been placed with the flush surface downwardly, however, this could have been reversed just as a blank may comprise extensions which have been etched down from opposite sides.

When the blank has been properly arranged on the lower tool portion (either manually or automatically, either as a single blank or as a biscuit comprising a plurality of blanks) the upper tool porticn is lowered and forced down against the blank. First the generally planar surface of the upper tool portion comes into contact with the upwardly facing second free surface of the base portion 301 (this step is not shown). Thereafter the base portion will be forced further down resulting in the extension being bend in the upward direction by the projection 201, generally in a direction perpendicular to a general plane of the blank. Due to the reduced thickness of the extension 302 plastic deformation will take place between the extension and the base with only minimal or no "lifting" of the base 301 from the surface of the upper tool portion. In the shown embodiment the downwards movement of the upper tool portion stops when the lower surface of the base portion contacts the upwardly facing surface of the lower tool portion, however, the downwards movement can be stopped before this happens as long as the desired plastic deformation is achieved. Indeed, without such a contact, some other kind of a stop-means has to be applied.

Finally, the upper tool part is lifted away and the finished item, or the processed blank, is removed from the bending tool, this resulting, for example, in a rim-like EMC metal gasket comprising a plurality of finger-like extensions alternating bend both up- and downwardly relative to the general plane of the gasket. The finished gasket is thereafter supplied to the customer as requested, e.g. as single units, in biscuits, on tape or in trays for SMD assembly, or mounted on shields.

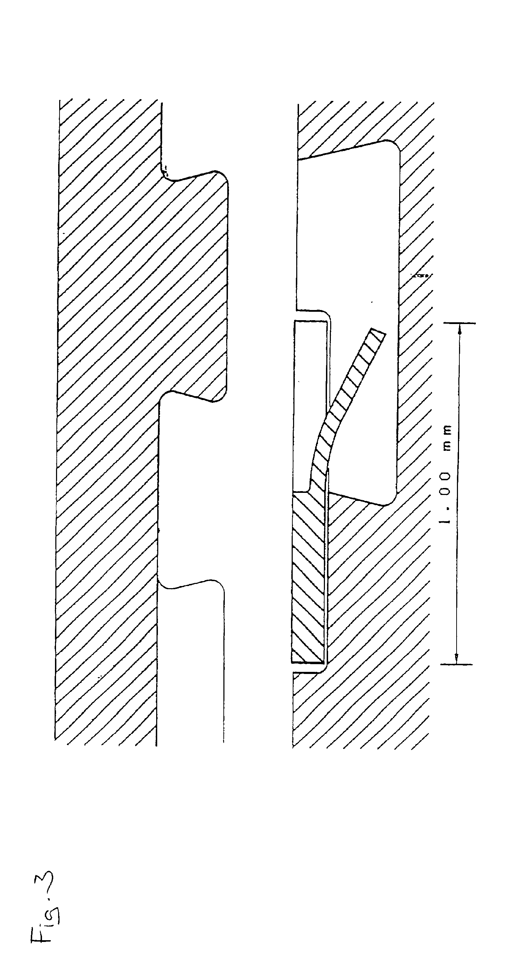

Fig. 3 shows a further embcdiment of a tool (drawn to scale) to be used with the present invention. In contrast to the above example, the blank is supported on its base portion. Further, the base portion is placed in a recess which then serves as a locating means for properly placing the blank in the lower tool portion.

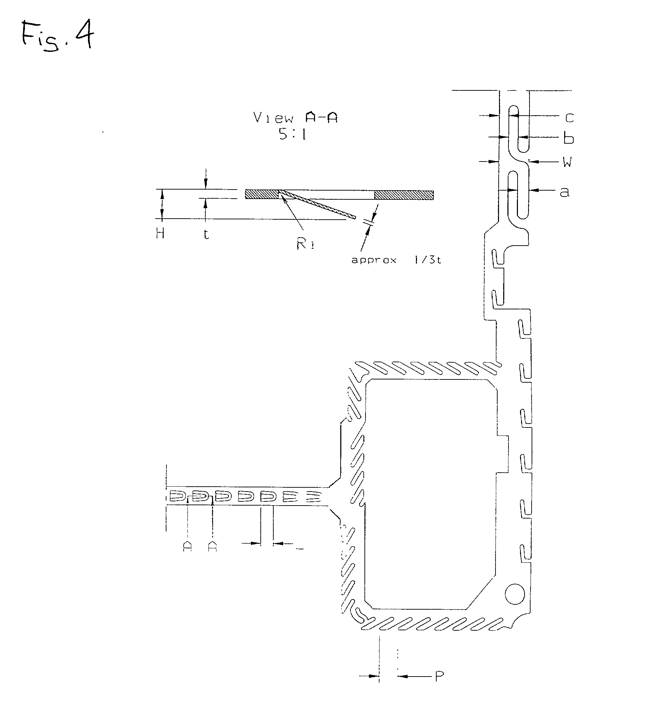

Fig. 4 shows (in partial) an actual embodiment of an EMC metal gasket which advantageously could be manufactured using the method of the present invention. As can be seen the gasket is made up of rim-like portions which in combination form one or more closed rim-portions of which one is shown. The following values given are only illustrative for this application and can be chosen according the desired application. Material example: 0.15 mm (= t) 7C27Mo2 hardened stainless steel; tensile strength: 1800 N/mm²; modulus of elasticity: 2.1 x 10⁵ N/mm²; width of frame W = 0.80 mm, length of springs L = typically 1-1.5 mm, height of springs H = typically 0.3-1.0 mm, minimum pitch between springs P = 1.2 mm; a not less than 0.30 mm, b not less than 0.25 mm and c not less than 0.25 mm.

As appears from the above, the pressing tools to be used with the present invention are rather delicate with recesses and projections having very small dimensions, i.e. height and depth less than 1 mm. To produce such tools, conventional cutting or spark machining can be used.

According to a second aspect of the invention a bending tool is manufactured using an etching technology principally as described above with respect to the manufacture of the blank. Indeed, etching techniques have been used extensively for the manufacture of printing plates; however, these are never supplied in matched pairs with a plurality of corresponding recesses and projections. If a surface on the etched tool is to have more than two "levels", for example when it is desirable that a tool portion on its "general" surface has both projections and extensions, then a two-step (or more) etching process will have to be applied with the application of further resist layers onto the partly etched tool member.

While the present invention has been described in connection with the preferred embodiment shown in the various figures, it is to be understood that other similar embodiments may be used or modifications and additions may be made to the described embodiment for performing the same function of the present invention without deviating there from. For example the base portion to which the extensions are attached could be attached to a further member, e.g. the base could form an edge portion of a shield housing. The base member does not solely have to be manufactured from a metal but could be made of any material or combination of materials which could be bend in a method according to the present invention

Therefore, the present invention should not be limited to any single embodiment, but rather construed in accordance with the appended claims.

## Claims

1. A method for bending at least one extension projecting from a base member, the method comprising the steps of:
- providing a blank comprising a base member (301) having at least one extension (302) projecting from the base member in a general plane of the base member, the base member and the extension both having a first surface and an opposite second surface, the extension having a reduced thickness relative to the portion of the base member to which it is attached;
- providing a bending tool comprising a first and a second tool portion, the tool portions comprising, when arranged in register with each other and the blank, at least one projection (201) on one of the tool portions and a corresponding recess (101) in the other tool portion into which the projection can be advanced;
- placing the blank in register between the two tool portions in such a way that the at least one extension member is arranged between the corresponding recess and projection;
- advancing the two tool portions toward each other until the first surface of the extension is in contact with the corresponding projection and the opposed second surface of the base member, in the vicinity of the projection, is in contact with an area just outside the corresponding recess, the first surface of the base member being free;
- further advancing the two tool portions toward each other, the projection forcing the extension into the recess thereby providing a plastic deformation substantially corresponding to the attachment of the extension to the base member, wherein the free first surface of the base member remains free during the initial or the entire movement of the extension into the recess;
- taking the two tool portions away from each and removing the processed blank comprising the bend at least one extension.

2. A method as defined in claim 1, wherein the blank comprises a plurality of extensions to be bend and the bending tool comprises a plurality of corresponding projections and recesses.

3. A method as defined in claim 2, wherein each of the two tool portions each comprise both at least one projection and at least one recess, whereby extensions on the blank can be bend in opposite directions.

4. A method as defined in any of claims 1-3, wherein the base member comprises a rim portion having a plurality of finger-like extensions arranged thereon.

5. A method as defined in any of claims 1-4, wherein the base member is a substantially planar, thin metal member, preferably with a thickness less than 1 mm.

6. A method as defined in claim 5, wherein the blank comprises at least one closed rim-like portion, the bend extensions forming spring contacts.

7. A method of manufacturing a bending tool comprising first and second tool portions, the tool portions comprising, when arranged in register with each other, at least one projection (201) on one of the tool portions and a corresponding recess (101) in the other tool portion, the method comprising the steps of:
- providing a first tool blank comprising a first surface and a second tool blank comprising a second surface;
- etching at least one recess in the first surface;
- etching the second surface to leave at least one projection corresponding to the at least one recess.

8. A method as defined in claim 7, wherein the two tool portions each comprise both at least one projection and at least one recess.

9. A method as defined in any of claims 1-6, wherein the tool is manufactured as defined in claim 7 or 8.

10. A method for bending a plurality of extensions projecting from a base member, the method comprising the steps of:
- providing a blank comprising a base member (301) having a plurality of extensions (302) projecting from the base member in a general plane of the base member, the base member and the extensions both having a first surface and an opposite second surface, the extensions having a reduced thickness relative to the portion of the base member to which they are attached;
- providing a bending tool comprising a first and a second tool portion, the tool portions comprising, when arranged in register with each other and the blank, a plurality of projections (201) and recesses (101) on one of the tool portions and corresponding recesses (101) and projections in the other tool portion, such that the projections can be advanced into the respective recesses;
- placing the blank in register between the two tool portions in such a way that each of the plurality of extension members is arranged between the corresponding recess and projection;
- advancing the two cool portions toward each other until a first surface of at least some of the extensions is in contact with the corresponding projection and the opposed second surface of the base member, in the vicinity of each of these projections, is in contact with an area just outside the corresponding recess, the corresponding first surface of the base member being free;
- further advancing the two tool portions toward each other, the projections forcing each of the extensions into the corresponding recess thereby providing a plastic deformation substantially corresponding to the attachment of the individual extensions to the base member, wherein the free first surface of the base member remains free during the initial or the entire movement of the extensions into the recesses;
- taking the two tool portions away from each and removing the processed blank comprising the plurality of bend extensions.
